# EUROPÄISCHE PATENTSCHRIFT

(11) **EP 2 062 296 B1**
(45) Veröffentlichungstag und Bekanntmachung des Hinweises auf die Patenterteilung: **05.07.2017**
(21) Anmeldenummer: 07817544.5
(22) Anmeldetag: 19.09.2007
(51) Int. Cl.: H01L 25/16, H01L 27/15, H01L 33/00

(54) **LED-HALBLEITERKÖRPER UND VERWENDUNG EINES LED-HALBLEITERKÖRPERS**
LED SEMICONDUCTOR BODY AND USE OF AN LED SEMICONDUCTOR BODY
ÉLÉMENT SEMI-CONDUCTEUR DEL ET SON UTILISATION

(30) Priorität: 28.09.2006 DE 102006046038
(43) Veröffentlichungstag der Anmeldung: 27.05.2009
(73) Patentinhaber: OSRAM Opto Semiconductors GmbH, 93055 Regensburg (DE)
(72) Erfinder: WINDISCH, Reiner, 93186 Pettendorf (DE); WIRTH, Ralph, 93098 Mintraching-Auhof (DE); GRÖTSCH, Stefan, 93077 Lengfeld-Bad Abbach (DE); BOGNER, Georg, 93138 Lappersdorf (DE); KIRCHBERGER, Günter, 93161 Sinzing (DE); STREUBEL, Klaus, 93164 Laaber (DE)
(74) Vertreter: Epping - Hermann - Fischer
(86) Internationale Anmeldenummer: PCT/DE2007/001693
(87) Internationale Veröffentlichungsnummer: WO 2008/040300

(56) Entgegenhaltungen:
- EP-A- 0 493 015
- DE-A1-102004 004 765
- US-A1- 2004 129 944
- US-B1- 6 323 598

## Beschreibung

Die Erfindung betrifft einen LED-Halbleiterkörper sowie Verwendungen eines derartigen LED-Halbleiterkörpers.

Die Druckschrift DE°102004004765°A1 beschreibt eine Halbleiterstruktur, welche eine aktive Zone aufweist.

Eine Leuchtdiode weist typischerweise eine Durchlassspannung von 1,5V bis 3,2V auf. Da gängige Betriebsspannungen in der Regel höher sind (zum Beispiel Autobatterie: 12V, Netzspannung je nach Land: 230V beziehungsweise 110V), kann die Leuchtdiode nicht unmittelbar an die Spannungsquellen angeschlossen werden. Daher wird die Leuchtdiode beispielsweise mit einem Vorwiderstand in Reihe geschaltet, wobei in der Regel am Vorwiderstand ein erheblicher Teil der Betriebsspannung abfällt. Dies führt zu einem geringen Wirkungsgrad, da der am Vorwiderstand abfallende Teil der Betriebsspannung nicht zur Strahlungserzeugung genutzt wird. Alternativ kann ein DC-DC-Wandler verwendet werden, der die Betriebsspannung in eine Wechselspannung zerhackt, wobei die Betriebsspannung auf die erforderliche Spannung herunter transformiert und anschließend gleichgerichtet wird. Diese Vorgehensweise erfordert einen beachtlichen Mehraufwand.

Es ist Aufgabe der vorliegenden Erfindung, einen LED-Halbleiterkörper anzugeben, der mittels einer vorgegebenen Betriebsspannung auf effiziente und einfache Weise betreibbar ist.

Diese Aufgabe wird durch einen LED-Halbleiterkörper gemäß Patentanspruch 1 gelöst.

Vorteilhafte Weiterbildungen und Ausgestaltungen der Erfindung sind Gegenstand der abhängigen Ansprüche.

Ein erfindungsgemäßer LED-Halbleiterkörper umfasst eine Anzahl von mindestens zwei strahlungserzeugenden aktiven Schichten, die jeweils eine Durchlassspannung aufweisen, wobei die Anzahl der Schichten derart an eine Betriebsspannung angepasst ist, dass die an einem zu den aktiven Schichten in Serie geschalteten Vorwiderstand abfallende Spannung höchstens so groß ist wie eine am LED-Halbleiterkörper abfallende Spannung.

Vorteilhafterweise kann mittels des erfindungsgemäßen LED-Halbleiterkörpers ein höherer Wirkungsgrad als mittels einer herkömmlichen Leuchtdiode erzielt werden, da durch die Anpassung der Anzahl der Schichten an die Betriebsspannung am Vorwiderstand ein vergleichsweise geringer Teil der Spannung abfällt. Darüber hinaus erfordert der erfindungsgemäße LED-Halbleiterkörper keine komplizierte Ansteuerung, sondern kann mittels einer einfachen Serienschaltung von Widerstand und LED-Halbleiterkörper betrieben werden.

Vorliegend kann die aktive Schicht beispielsweise einen pn-Übergang, eine Doppelheterostruktur, einen Einfach-Quantentopf oder eine Mehrfach-Quantentopfstruktur (MQW) aufweisen.

Gemäß einer bevorzugten Ausführungsform ist die am Vorwiderstand abfallende Spannung kleiner als die kleinste im LED-Halbleiterkörper abfallende Durchlassspannung. Mit anderen Worten wird der LED-Halbleiterkörper solange um eine zusätzliche aktive Schicht erweitert, bis durch die Hinzunahme einer weiteren aktiven Schicht mit der kleinsten Durchlassspannung die am LED-Halbleiterkörper abfallende Spannung größer wäre als die Betriebsspannung. Bei dieser Ausführungsform wird die verfügbare elektrische Energie auf optimale Weise in Strahlüngsenergie umgewandelt, da die am Vorwiderstand abfallende Spannung minimal wird.

Gemäß einer weiter bevorzugten Ausführungsform sind die aktiven Schichten in dem Halbleiterkörper monolithisch integriert. Dadurch entfällt der Herstellungsschritt des Verbindens eines ersten Schichtstapels, der die erste aktive Schicht aufweist, mit einem zweiten Schichtenstapel, der die zweite aktive Schicht aufweist, beispielsweise mittels Bonden.

Bei einer vorteilhaften Weiterbildung des LED-Halbleiterkörpers ist zwischen der ersten aktiven Schicht und der zweiten aktiven Schicht ein Tunnelübergang ausgebildet. Dieser Tunnelübergang dient als elektrische Verbindung zwischen der ersten und zweiten aktiven Schicht. Beispielsweise kann ein solcher Tunnelübergang mittels einer hochdotierten Schicht eines ersten Leitfähigkeitstyps und einer hochdotierten Schicht eines zweiten Leitfähigkeitstyps gebildet sein.

Vorzugsweise sind bei dieser Weiterbildung die erste und die zweite aktive Schicht gleichsinnig angeordnet, so dass also deren pn-Übergänge eine pn-pn- bzw. np-np-Struktur bilden, wobei die pn-Übergänge mittels des dazwischen liegenden Tunnelübergangs elektrisch in Serie geschaltet sind. Es können im Rahmen der vorliegenden Erfindung in ähnlicher Weise auch drei oder mehr aktive Schichten in dem LED-Halbleiterkörper vertikal übereinander angeordnet sein, die in entsprechender Weise durch jeweils einen zwischen zwei benachbarten aktiven Schichten gebildeten Tunnelübergang verbunden sind.

Es ist auch denkbar, dass der Halbleiterkörper aus separat gefertigten Schichtenstapeln zusammengesetzt ist. In diesem Fall wird der Halbleiterkörper vorzugsweise ohne Tunnelübergang ausgebildet. Ferner können die separat gefertigten Schichtenstapel Dünnfilm-Halbleiterkörper sein.

Besonders bevorzugt sind die aktiven Schichten in vertikaler Richtung übereinander angeordnet. Vorliegend wird mit der vertikalen Richtung eine senkrecht zu einer Haupterstreckungsrichtung der aktiven Schichten verlaufende Richtung bezeichnet.

Bei einer ersten Variante des LED-Halbleiterkörpers emittieren die erste und die zweite aktive Schicht Strahlung gleicher Wellenlänge. Vorteilhafterweise wird so gegenüber herkömmlichen LED-Halbleiterkörpern die Strahlungsmenge und insbesondere die Strahlungsdichte für eine vorgegebene Wellenlänge vorteilhaft erhöht.

Bei einer zweiten Variante des LED-Halbleiterkörpers erzeugen die erste und die zweite aktive Schicht Strahlung verschiedener Wellenlänge. Diese Variante weist den Vorteil auf, dass das Emissionsspektrum des LED-Halbleiterkörpers insgesamt verbreitet ist. Dies ist insbesondere vorteilhaft zur Erzeugung mischfarbigen Lichts, bevorzugt weißen Lichts.

Gemäß einer bevorzugten Ausgestaltung ist der LED-Halbleiterkörper mit dem Vorwiderstand in einen Chip integriert. Im Gegensatz zu einer herkömmlichen Leuchtdiode, bei der ein erheblicher Teil der Betriebsspannung am Vorwiderstand abfällt, wodurch sich dieser stark erwärmt, ist erfindungsgemäß die Wärmeentwicklung am Vorwiderstand relativ gering. Daher kann der Vorwiderstand mit dem LED-Halbleiterkörper in einen Chip integriert werden, ohne dass Beeinträchtigungen des Halbleiterkörpers durch die verursachte Wärmeentwicklung zu befürchten sind.

Gemäß einer weiteren Ausgestaltung ist der LED-Halbleiterkörper mit dem Vorwiderstand in einen Gehäusekörper integriert. Auch bei dieser Ausgestaltung gilt, dass vorteilhafterweise keine Beeinträchtigungen des Halbleiterkörpers durch Wärmeentwicklung am Vorwiderstand zu befürchten sind.

Die beiden Ausgestaltungen mit integriertem Vorwiderstand ermöglichen ein kompaktes Bauelement, für dessen Inbetriebnahme allein die Angabe der benötigten Betriebsspannung genügt und bei dem eine Kontrolle des Betriebsstromes entfällt.

Gemäß einer ersten Variante wird der LED-Halbleiterkörper vorzugsweise mittels einer Gleichspannung betrieben. Hierdurch ist eine kontinuierliche Strahlungserzeugung mittels des LED-Halbleiterkörpers möglich.

Bevorzugte Betriebsspannungen sind 5V, 12V oder 24V. Dies sind Betriebsspannungen, die von gängigen Spannungsquellen wie beispielsweise Standardnetzteilen oder Batterien, insbesondere Autobatterien, geliefert werden können.

Zweckmäßigerweise umfasst der LED-Halbleiterkörper für einen elektrischen Anschluss einen ersten und einen zweiten außen liegenden Kontakt. Mittels der elektrischen Kontakte, die vorzugsweise auf einer Oberfläche des LED-Halbleiterkörpers aufgebracht sind, kann der LED-Halbleiterkörper mit einer Spannungsquelle elektrisch leitend verbunden werden. Insbesondere kann mittels des ersten und des zweiten außen liegenden Kontakts eine erste Betriebsspannung an den LED-Halbleiterkörper angelegt werden.

Zusätzlich zu den beiden außen liegenden Kontakten kann der LED-Halbleiterkörper einen innen liegenden Kontakt aufweisen, der zwischen zwei aktiven Schichten angeordnet ist. Insbesondere kann mittels des ersten oder zweiten außen liegenden Kontakts und des innen liegenden Kontakts eine zweite Betriebsspannung an den LED-Halbleiterkörper angelegt werden. Bei einer Serienschaltung und gleichsinniger Anordnung der beiden aktiven Schichten ist die zweite Betriebsspannung üblicherweise kleiner als die erste Betriebsspannung. Der Vorteil einer Anordnung mit mindestens einem innen liegenden Kontakt ist, dass der LED-Halbleiterkörper mittels verschiedener Betriebsspannungen betrieben werden kann. Dadurch kann ein "Spannungs-Kaskaden"-LED-Halbleiterkörper realisiert werden. Prinzipiell kann der LED-Halbleiterkörper eine Mehrzahl von innen liegenden Kontakten aufweisen.

Gemäß einer bevorzugten Variante weist der LED-Halbleiterkörper drei innen liegende Kontakte auf. Beispielsweise kann mittels des ersten außen liegenden Kontakts und des ersten innen liegenden Kontakts eine Betriebsspannung von 5V an den LED-Halbleiterkörper angelegt werden. Ferner kann mittels des ersten außen liegenden Kontakts und des zweiten innen liegenden Kontakts eine Betriebsspannung von 9V an den LED-Halbleiterkörper angelegt werden. Weiterhin kann mittels des ersten außen liegenden Kontakts und des dritten innen liegenden Kontakts eine Betriebsspannung von 12V an den LED-Halbleiterkörper angelegt werden. Schließlich ist es möglich, mittels des ersten außen liegenden Kontakts und des zweiten außen liegenden Kontakts eine Betriebsspannung von 24V an den LED-Halbleiterkörper anzulegen. Es sei angemerkt, dass vorzugsweise der erste innen liegende Kontakt dem ersten außen liegenden Kontakt in vertikaler Richtung nachgeordnet ist, während der zweite innen liegende Kontakt dem ersten innen liegenden Kontakt und der dritte innen liegende Kontakt dem zweiten innen liegenden Kontakt in vertikaler Richtung nachgeordnet ist. Besonders bevorzugt ist der zweite außen liegende Kontakt wiederum dem dritten innen liegenden Kontakt in vertikaler Richtung nachgeordnet. Ferner sei darauf hingewiesen, dass die Erfindung selbstverständlich nicht auf die angegebenen Spannungswerte festgelegt ist. Vielmehr können die innen liegenden Kontakte zwischen den aktiven Schichten derart angeordnet sein, dass der LED-Halbleiterkörper mittels gängiger verfügbarer Spannungsquellen betreibbar ist.

Gemäß einer ersten Variante sind die aktiven Schichten in Serie geschaltet. Dabei sind die aktiven Schichten vorzugsweise gleichsinnig angeordnet, das heißt dass deren pn-Übergänge eine pn-...-pn- bzw. np-...-np-Struktur bilden.

Gemäß einer zweiten Variante sind zwei aktive Schichten des LED-Halbleiterkörpers antiparallel verschaltet. Auch hierbei können die aktiven Schichten gleichsinnig angeordnet sein, so dass deren pn-Übergänge eine pn-pn- bzw. np-np-Struktur bilden.

Die Betriebsspannung, mittels welcher der LED-Halbleiterkörper gemäß der zweiten Variante betreibbar ist, ist vorzugsweise eine Wechselspannung. In diesem Fall ist abwechselnd eine der beiden Schichten strahlungsaktiv. Vorteilhafterweise erleichtert dies den Betrieb des erfindungsgemäßen LED-Halbleiterkörpers mittels einer haushaltsüblichen Wechselspannung, da für den Betrieb nicht wie bei einem herkömmlichen LED-Halbleiterkörper ein Gleichrichter notwendig ist. Beispielsweise kann der LED-Halbleiterkörper als Ersatz für eine Glühlampe verwendet werden. Wechselspannungen, die erfindungsgemäß als Betriebsspannungen in Frage kommen, können beispielsweise 2V, 12V oder 18V betragen.

Gemäß einer Ausführungsform kann der Halbleiterkörper, vorzugsweise mindestens eine der aktiven Schichten, AlₙGaₘIn₁₋ₙ₋ₘP enthalten, wobei 0 ≤ n ≤ 1, 0 ≤ m ≤ 1 und n+m ≤ 1 ist.

Gemäß einer weiteren Ausführungsform kann der Halbleiterkörper, vorzugsweise mindestens eine der aktiven Schichten, AlₙGaₘIn₁₋ₙ₋ₘAs enthalten, wobei 0 ≤ n ≤ 1, 0 ≤ m ≤ 1 und n+m ≤ 1 ist.

Gemäß einer weiteren Ausführungsform kann der Halbleiterkörper, vorzugsweise mindestens eine der aktiven Schichten, AlₙGaₘIn₁₋ₙ₋ₘN enthalten, wobei 0 ≤ n ≤ 1, 0 ≤ m ≤ 1 und n+m ≤ 1 ist.

Der LED-Halbleiterkörper ist vorzugsweise ein Dünnfilm-Halbleiterkörper. Umfasst der LED-Halbleiterkörper eine Mehrzahl von Schichtenstapeln, so sind diese insbesondere mittels Dünnschicht-Technik hergestellt.
Ein Dünnfilm-Halbleiterkörper zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Dünnfilm-Halbleiterkörper ist in guter Näherung ein Lambert'scher Oberflächenstrahler und eignet sich von daher besonders gut für die Anwendung in einem Scheinwerfer.

Bei Beleuchtungen wie zum Beispiel Allgemeinbeleuchtungen oder Fahrzeugbeleuchtungen weisen die zur Verfügung stehenden Spannungsquellen in der Regel eine vorgegebene unveränderliche Betriebsspannung auf. Vorteilhafterweise kann der erfindungsgemäße LED-Halbleiterkörper an diese Betriebspannungen mittels der Anzahl der aktiven Schichten angepasst werden.

Weiterhin kann der LED-Halbleiterkörper mit Vorteil zur Hinterleuchtung, beispielsweise von Displays, oder für Projektionsanwendungen verwendet werden.

Zweckmäßigerweise kann der erfindungsgemäße LED-Halbleiterkörper als Strahlungsquelle in einem strahlungsemittierenden Bauelement dienen, wobei auch das strahlungsemittierende Bauelement für die genannten Verwendungen geeignet ist.

Weitere Merkmale, Vorteile und Weiterbildungen der Erfindung ergeben sich aus den nachfolgend in Verbindung mit den Figuren 1 bis 5 erläuterten Ausführungsbeispielen.

Es zeigen:
Figur 1 ein Blockschaltbild einer Anordnung umfassend einen Vorwiderstand und ein erstes Ausführungsbeispiel eines erfindungsgemäßen LED-Halbleiterkörpers,
Figur 2 eine schematische Querschnittsansicht des ersten Ausführungsbeispiels eines LED-Halbleiterkörpers,
Figur 3 eine schematische Querschnittsansicht eines zweiten Ausführungsbeispiels eines erfindungsgemäßen LED-Halbleiterkörpers,
Figur 4 ein Blockschaltbild einer Anordnung umfassend einen Vorwiderstand und ein drittes Ausführungsbeispiel eines erfindungsgemäßen LED-Halbleiterkörpers,
Figur 5 eine schematische Querschnittsansicht des dritten Ausführungsbeispiels eines erfindungsgemäßen LED-Halbleiterkörpers.

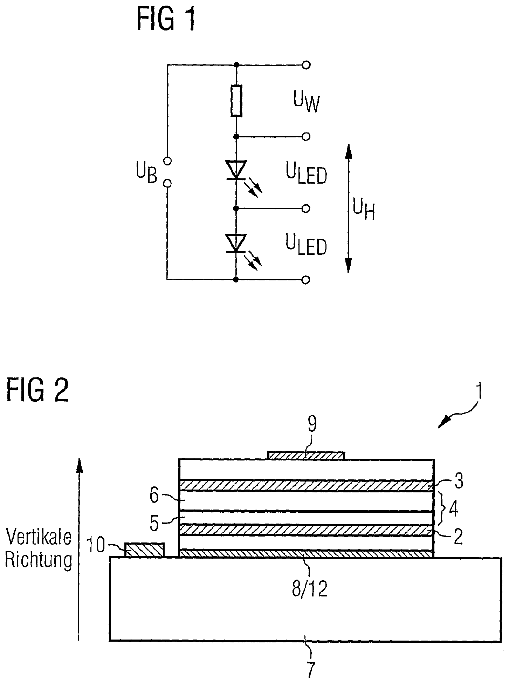

Die dem in Figur 1 dargestellten Blockschaltbild zugrunde liegende Anordnung umfasst eine Spannungsquelle, einen Vorwiderstand und einen LED-Halbleiterkörper mit zwei aktiven Schichten. Die Spannungsquelle liefert eine Betriebsspannung U_{B}, die vorzugsweise eine Gleichspannung ist. An die Spannungsquelle ist ein LED-Halbleiterkörper angeschlossen, dessen aktive Schichten eine Durchlassspannung U_{LED} aufweisen. Im Betrieb wird in den beiden aktiven Schichten, die in Durchlassrichtung angeordnet sind, Strahlung erzeugt, was durch Pfeile angedeutet ist.

Die Anzahl der aktiven Schichten ist derart an die Betriebsspannung U_{B} angepasst, dass eine an dem Vorwiderstand abfallende Spannung Uw höchstens so groß ist wie eine am LED-Halbleiterkörper abfallende Spannung U_{H}.

Beispielsweise ist bei einer Autobatterie eine Betriebsspannung U_{B} = 12V verfügbar. Die Durchlassspannung U_{LED} der beiden aktiven Schichten kann zum Beispiel 3V betragen. Da die aktiven Schichten in Serie geschaltet sind, beläuft sich die am LED-Halbleiterkörper abfallende Spannung U_{H} auf 6V. Somit ist die am Vorwiderstand abfallende Spannung Uw = 6V und ist also gleich groß wie die Summe der einzelnen Durchlassspannungen U_{LED}. Im Vergleich zu einem herkömmlichen LED-Halbleiterkörper, der nur eine aktive Schicht aufweist, können mittels des erfindungsgemäßen LED-Halbleiterkörpers 25% mehr an elektrischer Energie zur Strahlungserzeugung genutzt werden. Damit weist der erfindungsgemäße LED-Halbleiterkörper mit Vorteil einen höheren Wirkungsgrad als der herkömmliche LED-Halbleiterkörper auf.

Der dem Blockschaltbild zugrunde liegende LED-Halbleiterkörper kann wie in Figur 2 dargestellt ausgebildet sein.

Der LED-Halbleiterkörper 1 gemäß Figur 2 weist eine erste strahlungserzeugende aktive Schicht 2 und eine zweite strahlungserzeugende aktive Schicht 3 auf, wobei die aktiven Schichten 2, 3 in vertikaler Richtung, das heißt senkrecht zu einer Haupterstreckungsrichtung der aktiven Schichten übereinander angeordnet sind. Zwischen den aktiven Schichten 2, 3 ist ein Tunnelübergang 4 ausgebildet, der mittels einer ersten Halbleiterschicht 5 eines ersten Leitfähigkeitstyps, beispielsweise einer n-leitenden Halbleiterschicht, und einer zweiten Halbleiterschicht 6 eines zweiten Leitfähigkeitstyps, beispielsweise einer p-leitenden Halbleiterschicht gebildet ist. Vorzugsweise sind diese beiden Halbleiterschichten 5, 6 hochdotiert ausgeführt, so dass im Betrieb ein effizienter Tunnelübergang mit einem geringen elektrischen Übergangswiderstand entsteht. Die aktiven Schichten 2, 3 sind gleichsinnig angeordnet, das heißt dass deren pn-Übergänge eine pn-pn- bzw. np-np-Struktur bilden. Mittels des Tunnelübergangs 4 sind die aktiven Schichten 2, 3 in Serie geschaltet.

Durch die Anordnung der beiden aktiven Schichten 2,3 in dem LED-Halbleiterkörper 1 ist die gesamte Durchlassspannung U_{LED} gegenüber einem herkömmlichen LED-Halbleiterkörper mit nur einer aktiven Schicht erhöht. Ferner ist die an dem Vorwiderstand 10 abfallende Spannung Uw geringer, wodurch die für die Strahlungserzeugung zur Verfügung stehende elektrische Energie mit Vorteil erhöht ist. Da sich die Abmessungen des LED-Halbleiterkörpers 1 gegenüber dem herkömmlichen LED-Halbleiterkörper nur unmaßgeblich ändern und insbesondere der Querschnitt des LED-Halbleiterkörpers 1 von der Zahl der aktiven Schichten unabhängig ist, wird zusätzlich zur Strahlungsmenge auch die Strahlungsdichte vorteilhaft erhöht.

Der Halbleiterkörper 1 ist auf einem Trägerelement 7 angeordnet. Eine dem Trägerelement 7 zugewandte Oberfläche des Halbleiterkörpers 1 ist bevorzugter Weise mit einer Reflexionsschicht 8 zur Reflexion der von den aktiven Schichten 2, 3 erzeugten Strahlung in vertikaler Richtung versehen. Besonders bevorzugt bildet die Reflexionsschicht 8 zugleich einen ersten außen liegenden Kontakt 12 für den LED-Halbleiterkörper 1. Auf einer dem Trägerelement 7 gegenüberliegenden Seite des LED-Halbleiterkörpers 1 kann insbesondere ein zweiter außen liegender Kontakt 9 ausgebildet sein. Somit wird ein vertikal leitfähiges Bauelement gebildet, das sich durch eine vergleichsweise homogene Stromverteilung innerhalb des LED-Halbleiterkörpers 1 auszeichnet.

Vorzugsweise ist der Vorwiderstand 10 auf dem Trägerelement 7 angeordnet. Diese Anordnung ist technisch deshalb sinnvoll, weil erfindungsgemäß die am Vorwiderstand 10 abfallende Spannung Uw vergleichsweise gering und somit auch die dabei entstehende Verlustwärme vergleichsweise gering ist. Dadurch ist die Gefahr von thermisch bedingten Störungen oder Beschädigungen reduziert. Die gemeinsame Anordnung des LED-Halbleiterkörpers 1 und des Vorwiderstands 10 auf dem Trägerelement 7 ermöglicht vorteilhafterweise eine vergleichsweise hohe Integrationsdichte.

Der LED-Halbleiterkörper 1 wird insbesondere auf einem gesonderten Aufwachssubstrat aufgewachsen und nachfolgend auf das Trägerelement 7 montiert, beispielsweise mittels Löten, Bonden oder Kleben, wobei vorzugsweise das Aufwachssubstrat von dem LED-Halbleiterkörper 1 abgelöst ist. Vorzugsweise ist der LED-Halbleiterkörper 1 ein Dünnfilm-Halbleiterkörper. Besonders bevorzugt emittieren die aktiven Schichten 2, 3 Strahlung gleicher Wellenlänge, wobei die vertikale Richtung die Hauptabstrahlrichtung angibt.

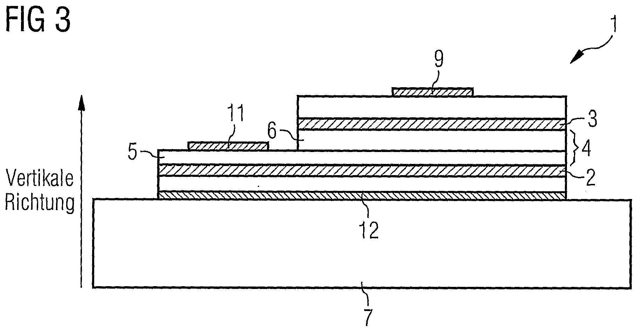

Der in Figur 3 dargestellte LED-Halbleiterkörper 1 umfasst für einen elektrischen Anschluss den ersten außen liegenden Kontakt 12, der beispielsweise rückseitig angeordnet ist, und den zweiten außen liegenden Kontakt 9, der beispielsweise vorderseitig angeordnet ist. Mittels des ersten und des zweiten außen liegenden Kontakts 12, 9 kann eine erste Betriebsspannung U_{B} an den LED-Halbleiterkörper 1 angelegt werden.

Zusätzlich zu den beiden außen liegenden Kontakten 9, 12 weist der LED-Halbleiterkörper 1 einen innen liegenden Kontakt 11 auf, der zwischen der ersten aktiven Schicht 2 und der zweiten aktiven Schicht 3 angeordnet ist. Mittels des ersten oder zweiten außen liegenden Kontakts 12, 9 und des innen liegenden Kontakts 11 kann eine zweite Betriebsspannung U_{B} an den LED-Halbleiterkörper 1 angelegt werden.

Bei einer Serienschaltung und gleichsinniger Anordnung der beiden aktiven Schichten 2, 3 ist die zweite Betriebsspannung kleiner als die erste Betriebsspannung. Der LED-Halbleiterkörper 1 kann also mittels verschiedener Betriebsspannungen betrieben werden.

Erfindungsgemäß können zwischen dem ersten außen liegenden Kontakt 12 und dem innen liegenden Kontakt 11 sowie zwischen dem zweiten außen liegenden Kontakt 12 und dem innen liegenden Kontakt 11 mehrere aktive Schichten angeordnet sein. Beispielsweise können jeweils zwei aktive Schichten mit einer Durchlassspannung U_{LED} = 2V dazwischen angeordnet sein. Zwischen dem ersten außen liegenden Kontakt 12 und dem innen liegenden Kontakt 11 kann dann die Betriebsspannung U_{B} = 5V angelegt werden, während zwischen dem ersten außen liegenden Kontakt 12 und dem zweiten außen liegenden Kontakt 9 die Betriebsspannung U_{B} = 9V angelegt werden kann. Die am Vorwiderstand abfallende Spannung ist vorteilhaft gering und beträgt Uw = 1V.

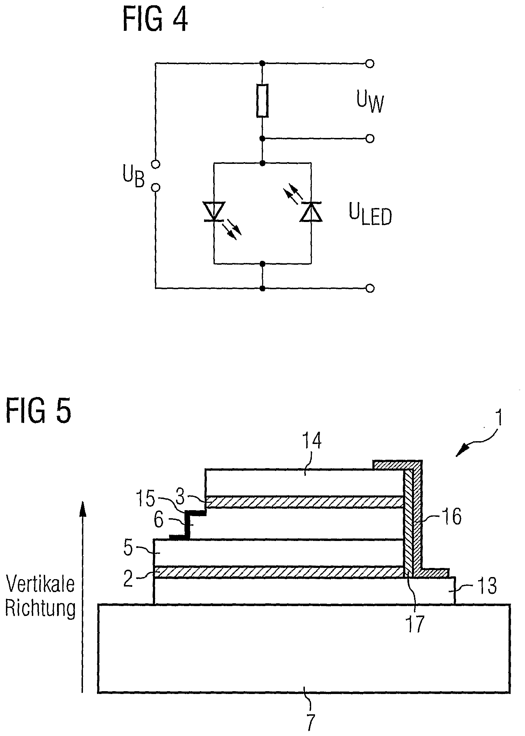

Die dem in Figur 4 dargestellten Blockschaltbild zugrunde liegende Anordnung umfasst eine Spannungsquelle, einen Vorwiderstand und einen LED-Halbleiterkörper mit zwei aktiven Schichten. Die Spannungsquelle liefert eine Betriebsspannung U_{B}, die vorzugsweise eine Wechselspannung ist. An die Spannungsquelle ist ein LED-Halbleiterkörper angeschlossen, dessen aktive Schichten eine Durchlassspannung U_{LED} aufweisen. Da die beiden aktiven Schichten antiparallel verschaltet sind, erzeugen diese im Falle einer Wechselspannung abwechselnd Strahlung.

Die Anzahl der aktiven Schichten ist derart an die Betriebsspannung U_{B} angepasst, dass die an dem Vorwiderstand abfallende Spannung Uw höchstens gleich groß ist wie die am LED-Halbleiterkörper abfallende Spannung U_{H}. Insbesondere entspricht die am LED-Halbleiterkörper abfallende Spannung U_{H} bei dieser Anordnung der jeweiligen in Durchlassrichtung gepolten Durchlassspannung U_{LED}.

Vorteilhafterweise erleichtert ein wie in der Anordnung gemäß Figur 4 verwendeter LED-Halbleiterkörper mit antiparallel verschalteten Schichten den Betrieb des erfindungsgemäßen LED-Halbleiterkörpers mittels einer haushaltsüblichen Wechselspannung, da für den Betrieb nicht wie bei einem herkömmlichen LED-Halbleiterkörper ein Gleichrichter notwendig ist. Beispielsweise kann der LED-Halbleiterkörper als Ersatz für eine Glühlampe verwendet werden.

Der dem Blockschaltbild zugrunde liegende LED-Halbleiterkörper kann wie in Figur 5 dargestellt ausgebildet sein.

Der LED-Halbleiterkörper 1 gemäß Figur 5 weist eine erste strahlungserzeugende aktive Schicht 2 und eine zweite strahlungserzeugende aktive Schicht 3 auf, wobei die aktiven Schichten 2, 3 in vertikaler Richtung, das heißt senkrecht zu einer Haupterstreckungsrichtung der aktiven Schichten übereinander angeordnet sind. Zwischen den aktiven Schichten 2, 3 sind eine erste Halbleiterschicht 5 eines ersten Leitfähigkeitstyps, beispielsweise eine n-leitende Halbleiterschicht, und eine zweite Halbleiterschicht 6 eines zweiten Leitfähigkeitstyps, beispielsweise eine p-leitende Halbleiterschicht, angeordnet. Auf der Rückseite wird der LED-Halbleiterkörper 1 durch eine erste außen liegende Halbleiterschicht 13 des zweiten Leitfähigkeitstyps und auf der Vorderseite durch eine zweite außen liegende Halbleiterschicht 14 des ersten Leitfähigkeitstyps begrenzt. Die aktiven Schichten 2, 3 sind gleichsinnig angeordnet, das heißt dass deren pn-Übergänge eine pn-pn- bzw. np-np-Struktur bilden.

Die Halbleiterschicht 5 ist mittels einer ersten Verbindungsschicht 15 mit der Halbleiterschicht 6 elektrisch leitend verbunden. Vorzugsweise ist die Verbindungsschicht 15 an einen ersten elektrischen Kontakt angeschlossen. Ferner ist die Halbleiterschicht 13 mittels einer zweiten Verbindungsschicht 16 mit der Halbleiterschicht 14 elektrisch leitend verbunden. Vorzugsweise ist die Verbindungsschicht 16 an einen zweiten elektrischen Kontakt angeschlossen. Um einen Kurzschluss zu vermeiden, ist die Verbindungsschicht 16 auf einer elektrischen Isolierschicht 17 angeordnet.

Der Halbleiterkörper 1 ist auf einem Trägerelement 7 angeordnet.

Es sei angemerkt, dass der erfindungsgemäße LED-Halbleiterkörper nicht auf die Ausführung beschränkt ist, in welcher die aktiven Schichten monolithisch integriert sind. Vielmehr kann der erfindungsgemäße LED-Halbleiterkörper auch aus einzelnen miteinander verbundenen Schichtenstapeln gebildet sein, die jeweils mindestens eine aktive Schicht aufweisen.

## Patentansprüche

1. LED-Halbleiterkörper (1) mit einer Anzahl von mindestens zwei strahlungserzeugenden aktiven Schichten (2, 3), die jeweils eine Durchlassspannung (U_{LED}) aufweisen,
wobei
- der LED-Halbleiterkörper (1) für einen elektrischen Anschluss einen ersten und einen zweiten außen liegenden Kontakt (12, 9) aufweist,
- mittels des ersten und des zweiten außen liegenden Kontakts (12, 9) eine erste Betriebsspannung (U_{B}) an den LED-Halbleiterkörper (1) anlegbar ist,
- der LED-Halbleiterkörper (1) einen innen liegenden Kontakt (11) aufweist, der zwischen zwei aktiven Schichten (2, 3) angeordnet ist, und
- mittels des ersten oder zweiten außen liegenden Kontakts (12, 9) und des innen liegenden Kontakts (11) eine zweite Betriebsspannung (U_{B}) an den LED-Halbleiterkörper (1) anlegbar ist,
**dadurch gekennzeichnet,**
**dass** die aktiven Schichten (2, 3) Strahlung gleicher Wellenlänge erzeugen.

2. LED-Halbleiterkörper (1) nach Anspruch 1, wobei
die aktiven Schichten (2, 3) in dem Halbleiterkörper (1) monolithisch integriert sind.

3. LED-Halbleiterkörper (1) nach einem der vorhergehenden Ansprüche, wobei
zwei aktive Schichten (2, 3) antiparallel verschaltet sind.

4. LED-Halbleiterkörper (1) nach Anspruch 1 oder 2, wobei
die aktiven Schichten (2, 3) in Serie geschaltet sind.

5. LED-Halbleiterkörper (1) nach einem der vorhergehenden Ansprüche, der ein Dünnfilm-Halbleiterkörper ist.

6. Anordnung umfassend eine Spannungsquelle, einen Vorwiderstand (10) und einen LED-Halbleiterkörper (1) nach einem der vorangehenden Ansprüche, wobei
- die Spannungsquelle eine Betriebsspannung (U_{B}) liefert,
- der Vorwiderstand zu den aktiven Schichten (2, 3) des LED-Halbleiterkörper in Serie geschaltet ist, und
- die Anzahl der aktiven Schichten derart an die Betriebsspannung (U_{B}) angepasst ist, dass die am Vorwiderstand (10) abfallende Spannung (Uw) höchstens so groß ist wie eine am LED-Halbleiterkörper (1) abfallende Spannung (U_{H}).

7. Anordnung nach Anspruch 6, wobei
die am Vorwiderstand (10) abfallende Spannung (Uw) kleiner ist als die kleinste im LED-Halbleiterkörper (1) abfallende Durchlassspannung (U_{LED}).

8. Anordnung nach Anspruch 6 oder 7, wobei der LED-Halbleiterkörper mit dem Vorwiderstand (10) in einen Chip integriert ist.

9. Anordnung nach einem der Ansprüche 6 bis 8, wobei
die Betriebsspannung (U_{B}) eine Gleichspannung ist.

10. Anordnung nach einem der Ansprüche 6 bis 8, wobei
die Betriebsspannung (U_{B}) eine Wechselspannung ist.

## Claims

1. LED semiconductor body (1) comprising a number of at least two radiation-generating active layers (2, 3) each having a forward voltage (U_{LED}), wherein
- the LED semiconductor body (1) has a first and a second outer contact (12, 9) for an electrical connection,
- a first operating voltage (U_{B}) is applicable to the LED semiconductor body (1) by means of the first and second outer contacts (12, 9),
- the LED semiconductor body (1) has an inner contact (11) which is arranged between two active layers (2, 3), and
- a second operating voltage (U_{B}) is applicable to the LED semiconductor body (1) by means of the first or second outer contact (12, 9) and the inner contact (11),
**characterized**
**in that** the active layers (2, 3) generate radiation of the same wavelength.

2. LED semiconductor body (1) according to Claim 1, wherein the active layers (2, 3) are monolithically integrated in the semiconductor body (1).

3. LED semiconductor body (1) according to one of the preceding claims, wherein
two active layers (2, 3) are connected antiparallel.

4. LED semiconductor body (1) according to Claim 1 or 2, wherein the active layers (2, 3) are connected in series.

5. LED semiconductor body (1) according to one of the preceding claims, which is a thin-film semiconductor body.

6. Arrangement comprising a voltage source, a series resistor (10) and an LED semiconductor body (1) according to one of the preceding claims, wherein
- the voltage source provides an operating voltage (U_{B}),
- the series resistor is connected in series with the active layers (2, 3) of the LED semiconductor body, and
- the number of active layers is adapted to the operating voltage (U_{B}) in such a manner that the voltage (Uw) dropping across the series resistor (10) is at most of the same magnitude as a voltage (U_{H}) dropping across the LED semiconductor body (1).

7. Arrangement according to Claim 6, wherein
the voltage (Uw) dropping across the series resistor (10) is less than the smallest forward voltage (U_{LED}) dropping in the LED semiconductor body (1).

8. Arrangement according to Claim 6 or 7, wherein the LED semiconductor body is integrated with the series resistor (10) in a chip.

9. Arrangement according to one of Claims 6 to 8, wherein the operating voltage (U_{B}) is a DC voltage.

10. Arrangement according to one of Claims 6 to 8, wherein the operating voltage (U_{B}) is an AC voltage.

## Revendications

1. Corps semi-conducteur à DEL (1) avec une quantité d'au moins deux couches actives (2, 3) produisant un rayonnement qui présentent respectivement une tension directe (U_{LED}),
- pour un branchement électrique, le corps semi-conducteur à DEL (1) comportant un premier et un deuxième contacts (12, 9) placés à l'extérieur,
- au moyen du premier et du deuxième contacts (12, 9) placés à l'extérieur, une première tension de service (U_{B}) étant applicable sur le corps semi-conducteur à DEL (1),
- le corps semi-conducteur à DEL (1) comportant un contact (11) placé à l'intérieur qui est disposé entre deux couches actives (2, 3) et
- au moyen du premier et du deuxième contacts (12, 9) placés à l'extérieur et du contact (11) placé à l'intérieur, une deuxième tension de service (U_{B}) étant applicable sur le corps semi-conducteur à DEL (1),
**caractérisé en ce que**
les couches actives (2, 3) génèrent un rayonnement de même longueur d'onde.

2. Corps semi-conducteur à DEL (1) selon la revendication 1,
les couches actives (2, 3) étant intégrées de manière monolithique dans le corps semi-conducteur (1).

3. Corps semi-conducteur à DEL (1) selon l'une quelconque des revendications précédentes,
deux couches actives (2, 3) étant interconnectées de manière antiparallèle.

4. Corps semi-conducteur à DEL (1) selon la revendication 1 ou 2,
les couches actives (2, 3) étant connectées en série.

5. Corps semi-conducteur à DEL (1) selon l'une quelconque des revendications précédentes, qui est un corps semi-conducteur à couche mince.

6. Agencement comprenant une source de tension, une pré-résistance (10) et un corps semi-conducteur à DEL (1) selon l'une quelconque des revendications précédentes,
- la source de tension fournissant une tension de service (U_{B}),
- la pré-résistance étant connectée en série sur les couches actives (2, 3) du corps semi-conducteur à DEL et
- la quantité des couches actives étant adaptée à la tension de service (U_{B}) de telle sorte que la tension (Uw) retombant sur la pré-résistance (10) soit au maximum aussi élevée qu'une tension (U_{H}) retombant sur le corps semi-conducteur à DEL (1).

7. Agencement selon la revendication 6,
la tension (Uw) retombant sur la pré-résistance (10) étant plus basse que la plus basse tension directe (U_{LED}) retombant dans le corps semi-conducteur à DEL (1).

8. Agencement selon la revendication 6 ou 7, le corps semi-conducteur à DEL étant intégré avec la pré-résistance (10) dans une puce.

9. Agencement selon l'une quelconque des revendications 6 à 8, la tension de service (U_{B}) étant une tension continue.

10. Agencement selon l'une quelconque des revendications 6 à 8, la tension de service (U_{B}) étant une tension alternative.
